# EUROPEAN PATENT APPLICATION

(11) **EP 2 091 072 A1**
(43) Date of publication of application: **19.08.2009**
(21) Application number: 07829652.2
(22) Date of filing: 12.10.2007
(51) Int. Cl.: H01L 21/285, G02F 1/1343, G02F 1/1368, G09F 9/00, H01L 21/28, H01L 21/3205, H01L 21/336, H01L 23/52, H01L 29/786

(54) **CONDUCTIVE FILM FORMING METHOD, THIN FILM TRANSISTOR, PANEL WITH THIN FILM TRANSISTOR AND THIN FILM TRANSISTOR MANUFACTURING METHOD**

(30) Priority: 12.10.2006 JP 2006278754
(71) Applicant: ULVAC, INC., Chigasaki-shi Kanagawa 253-8543 (JP)
(72) Inventor: TAKASAWA, Satoru, Sammu-Shi Chiba 289-1226 (JP); TAKEI, Masaki, Sammu-Shi Chiba 289-1226 (JP); TAKAHASHI, Hirohisa, Sammu-Shi Chiba 289-1226 (JP); UKISHIMA, Sadayuki, Sammu-Shi Chiba 289-1226 (JP); TANI, Noriaki, Sammu-Shi Chiba 289-1226 (JP); ISHIBASHI, Satoru, Sammu-Shi Chiba 289-1226 (JP)
(74) Representative: Körber, Martin Hans
(86) International application number: PCT/JP2007/069916
(87) International publication number: WO 2008/044757

(57) **Abstract**

An electroconductive film having high adhesion and a low resistivity is formed. An electroconductive film 25 composed mainly of copper and containing an addition metal such as Ti is formed by sputtering a target composed mainly of copper in a vacuum atmosphere into which a nitriding gas is introduced. Such an electroconductive film 25 has high adhesion to a silicon layer 23 and a substrate 22, and is hardly peeled from the substrate 22. Further, since the electroconductive film has a low resistivity and a low contact resistance to a transparent electroconductive film, the electric characteristics do not degrade even when it is used as an electrode film. The electroconductive film formed by the present invention is suitable particularly as a barrier film for an electrode of a TFT or a semiconductor element.

## Description

### TECHNICAL FIELD

The present invention generally relates to metallic wiring films for electronic parts and a sputtering method as a method for forming such films.

### BACKGROUND ART

Heretofore, low-resistance materials (such as, Al and Cu, Mo, or Cr) have been used in metallic wiring films for electronic parts. For instance, in the case of the TFT (Thin film transistor) liquid crystal displays, a demand for the reduction in the resistance of the wiring electrodes has been increasing with the enlargement of the panels, and the necessity for using Al and Cu as the low-resistance wirings has been growing.

In the case of the Al wiring used in a TFT, there have been problems in that, for example, a hillock occurs in a post process, diffusion occurs into an underling Si layer when the Al wirings are used as source and drain electrodes, and a contact resistance between the wiring and a transparent electrode made of ITO (indium-tin oxide) degrades. In order to avoid such problems, a barrier layer on opposing sides of which alloy layers composed mainly of Mo or Cr or an alloy thereof are laminated becomes necessary.

On the other hand, with respect to the Cu wiring, Cu is a material having a lower resistance than that of Al. Although degradation in the contact resistance between Al and the ITO transparent electrode poses a problem, Cu exhibits an excellent contact resistance because of its resistance to oxidation.

Consequently, a need for the use of Cu as a low-resistance wiring film has been increasing. However, as compared to other wiring materials, there have been problems in that Cu has poor adhesion to underlying materials (such as, glass and Si), and Cu diffuses into a Si layer when it is used as source and drain electrodes. A barrier layer is required at an interface between the Cu wiring and other layer so as to enhance the adhesion and prevent the diffusion.

Regarding an underlying Cu seed layer made of a Cu plating, which is used in a semiconductor, a barrier layer is required to prevent the diffusion of TiN, TaN or the like from the same diffusion problem as described above.

As to related patents on metallic wiring films composed mainly of Cu for electronic parts, a technique characterized by adding an element such as Mo into Cu (JP-A 2005-158887) and a technique characterized by introducing nitrogen or oxygen during a film-forming method by sputtering pure Cu (JP-A 10-12151) are known. However, both of technologies have problems in adhesion, reduced resistance and resistance to a hillock.
Patent Document: JP-A 2005-158887
Patent Document: JP-A 10-12151

### DISCLOSURE OF THE INVENTION

### PROBLEMS TO BE SOLVED BY THE INVENTION

The present invention is to solve the problems of the prior art as described above, and is aimed at providing a method for producing a Cu-based wiring film and a film of a Cu-based barrier layer, which are excellent in terms of reduced resistance, a contact resistance between an ITO transparent electrode, adhesion to glass and Si, prevention of diffusion into an Si layer when the Cu-based wiring film is used as source and drain electrodes, a hillock resistance, and film characteristics required for these devices.

### MEASURES FOR SOLVING THE PROBLEMS

In order to solve the above problems, the present invention is directed to an electroconductive film-forming method for forming an electroconductive film composed mainly of copper and contains an addition metal on a surface of an object to be film-formed in a vacuum atmosphere by a sputtering method, the forming-method comprising sputtering a target composed mainly of copper in the vacuum atmosphere, while feeding a nitriding gas having a nitrogen atom in a chemical structure thereof into the vacuum atmosphere, ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target, and forming the electroconductive film.

The present invention is directed to the electroconductive film-forming method, wherein the object to be film-formed is used, in which any one or more of a silicon layer, a glass substrate and a transparent electroconductive film are exposed from a surface of the object.

The present invention is directed to the electroconductive film-forming method, wherein Ti is selected as the addition metal, a nitrogen gas is used as the nitriding gas, the nitrogen gas is introduced in such a manner that a partial pressure of the nitrogen gas to the total pressure of the vacuum atmosphere may be 0.1% or more and 50% or less, and Ti is contained in the electroconductive film by 0.1 atomic% or more.

The present invention is directed to a thin film transistor comprising a gate electrode, a drain area composed mainly of silicon and a source area composed mainly of silicon, wherein the drain area and the source area are electrically conducted when a voltage is applied to the gate electrode and wherein a first electroconductive film mainly composed of copper is formed on either one or both of a surface of the drain area and that of the source area, the first electroconductive film is formed by arranging in a vacuum atmosphere an object to be film-formed in which either one or both of the drain area and the source area are exposed, sputtering a target composed mainly of copper in the vacuum atmosphere, while feeding a nitriding gas having a nitrogen atom in a chemical structure into the vacuum atmosphere, and ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target.

The present invention is directed to the thin film transistor, wherein the first electroconductive film contains Ti as the addition metal by 0.1 atomic% or more and the first electroconductive film is formed by feeding the nitriding gas composed of a nitrogen gas in such a manner that a partial pressure of the nitriding gas to the total pressure of the vacuum atmosphere may be 0.1% or more to 50% or less.

The present invention is directed to a thin film transistor-provided panel comprising a substrate, and a thin film transistor and a transparent electroconductive film disposed on a surface of the substrate, respectively, wherein the thin film transistor comprises a gate electrode, a drain area composed mainly of silicon and a source area composed mainly of silicon. When a voltage is applied to the gate electrode, the drain area and the source area are electrically conducted and the transparent electroconductive film is connected to the source area. A first electroconductive film composed mainly of copper is formed on either one or both of a surface of the drain area and that of the source area; and the first electroconductive film is formed by arranging in a vacuum atmosphere an object to be film-formed in which either one or both of the drain area and the source area are exposed, sputtering a target composed mainly of copper in the vacuum atmosphere while feeding a nitriding gas having a nitrogen atom in a chemical structure into the vacuum atmosphere, and ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target.

The present invention is directed to the thin film transistor-provided panel, wherein the first electroconductive film is tightly adhered to both of the drain area and the transparent electroconductive film.

The present invention is directed to the thin film transistor-provided panel, wherein Ti is selected as the addition metal, a nitrogen gas is used as the nitriding gas, the nitrogen gas is introduced in such a manner that a partial pressure of the nitrogen gas to the total pressure of the vacuum atmosphere may be 0.1% or more and 50% or less, and Ti is contained in the first electroconductive film by 0.1 atomic% or more.

The present invention is directed to the thin film transistor-provided panel, wherein a second electroconductive film electrically connected to the first electroconductive film is disposed on a surface of the first electroconductive film; and the transparent electroconductive film is arranged on a surface of the second electroconductive film. The second electroconductive film is formed by arranging, in a vacuum atmosphere, the substrate in which the thin film transistor and the first electroconductive film have been formed, sputtering a target composed mainly of copper in the vacuum atmosphere while feeding a nitriding gas having a nitrogen atom in a chemical structure into the vacuum atmosphere, and ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target.

The present invention is directed to the thin film transistor-attached panel, wherein a copper film composed mainly of copper is arranged on a surface of the first electroconductive film, the object to be film-formed in which the copper film is exposed is used, and the second electroconductive film is formed on a surface of the copper film.

The present invention is directed to the thin film transistor-provided panel, wherein Ti is selected as the addition metal, a nitrogen gas is used as the nitriding gas, the nitrogen gas is introduced in such a manner that a partial pressure of the nitrogen gas to the total pressure of the vacuum atmosphere may be 0.1% or more and 50% or less, and Ti is contained in the second electroconductive film by 0.1 atomic% or more.

The present invention is directed to a method for producing a thin film transistor comprising an electroconductive film which is in contact with one or more of a silicon layer composed mainly of silicon, a glass substrate and a transparent electroconductive film, wherein the electroconductive film is composed mainly of copper, the producing method comprising sputtering a target composed mainly of copper in a vacuum atmosphere, while feeding a nitriding gas having a nitrogen atom in a chemical structure into the vacuum atmosphere, in such a state where an object to be film-formed in which any one or more of the silicon layer, the glass substrate and the transparent electroconductive film are exposed is arranged in the vacuum atmosphere, ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target, and forming the electroconductive film.

The present invention is directed to the thin film transistor-producing method, wherein the nitriding gas is introduced in such a manner that a partial pressure of the nitriding gas to the total pressure of the vacuum atmosphere may be 0.1% or more and 50% or less, and the sputtering is performed.

The present invention is directed to a method for producing a thin film transistor comprising a silicon layer composed mainly of silicon, a first electroconductive film in contact with the silicon layer, a copper film composed mainly of copper and formed on a surface of the first electroconductive film, and a second electroconductive film formed on a surface of the copper film, wherein a transparent electroconductive film is in contact with the second electroconductive film and the first and second electroconductive films are composed mainly of copper, the thin film transistor-producing method comprising sputtering a target composed mainly of copper in a vacuum atmosphere, while feeding a nitriding gas having a nitrogen atom in a chemical structure into the vacuum atmosphere, ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target, and forming either one or both of the first and second electroconductive films.

The present invention is directed to the thin film transistor-producing method, wherein the nitriding gas is introduced in such a manner that a partial pressure of the nitriding gas to the total pressure of the vacuum atmosphere may be 0.1% or more and 50% or less, and the sputtering is performed.

It is noted that the first and second electroconductive films may be integrated so long as they are electrically connected to each other; alternatively, another electroconductive film (such as a pure copper film) may be disposed closely between the first and second electroconductive films.

The present invention is constructed as described above, and the target (a target portion) is constituted by a main target composed mainly of copper and an auxiliary target composed mainly of the addition metal; alternatively, the target (a target portion) is constituted by an alloy target composed mainly of copper and containing the addition metal. In either case, when the target portion is sputtered, copper atoms and atoms of the addition metal are ejected.

The main component in the present invention means that the atoms as the main component are contained in 50 at% (atomic %) or more. That is, as to the target composed mainly of copper, it contains not less than 50 at% of the copper atoms.

Meanwhile, the pure copper in the present invention contains not less than 99.9 at% of copper. Although the first and second electroconductive films are composed mainly of copper, they contain the addition metal, and the content of copper is lesser therein (less than 99.9 at%) than the pure copper.

Any one or both of the content of the nitrogen atoms and the content of the addition metal are smaller in the copper film than in the first and second electroconductive films, and the resistivity of the copper film is smaller than that of any one of the first and second electroconductive films.

In order to reduce the content of the addition metal, the film is formed by sputtering a target having a smaller content of the addition metal (for example, a target of pure copper) in the vacuum atmosphere. When the pure copper target is used, the content of the addition metal in the pure copper target is less than 0.01 at%.

In order to reduce the content of the nitrogen atoms, the copper film is formed by sputtering the copper target in the vacuum atmosphere having a lower partial pressure of the nitriding gas than in the case of the vacuum atmosphere (first vacuum atmosphere) in which the first and second electroconductive films are formed.

### EFFECTS OF THE INVENTION

According to the present invention, the electroconductive film having a low resistance and high adhesion to the object to be film-formed can be obtained. Further, when the electroconductive film is formed so as to be tightly adhered to the silicon layer, copper does not diffuse into that silicon layer. When the electroconductive film is formed so as to be tightly adhered to the transparent electroconductive film, the contact resistance to the transparent electroconductive film is also low. Therefore, the electroconductive film is suitable particularly as a film to be tightly adhered to the silicon layer or the transparent electroconductive film, and is more particularly suitable as a source electrode and a drain electrode of a TFT and a barrier film for these electrodes.

### BRIEF DESCRIPTION OF THE DRAWINGS

Fig. 1 is a sectional view for illustrating one embodiment of a film-forming apparatus to be used in the present invention.
Figs. 2(a) to (c) are sectional views for illustrating steps of forming an electroconductive film and a copper film.
Fig. 3 is a graph showing the relationship between the partial pressure of the nitrogen gas and the resistivity (Ti).
Fig. 4 is a graph showing the relationship between the post-annealing temperature and the resistivity (Ti).
Fig. 5 is an electron microscope photograph showing the diffusiveness of a silicon layer in an electroconductive film.
Fig. 6 is an electron microscope photograph showing the dispersibility of a silicon layer in a copper film.
Figs. 7(a) to (d) are sectional views for illustrating a former half portion of steps of producing a TFT panel as a first embodiment.
Figs. 8(a) and (b) are sectional views for illustrating a latter half portion of the steps of producing the TFT panel as the first embodiment.
Fig. 9 is a sectional view for illustrating a second embodiment of the TFT panel according to the present invention.
Fig. 10 is a sectional view for illustrating a third embodiment of the TFT panel according to the present invention.
Fig. 11 is a graph showing the relationship between the partial pressure of the nitrogen gas and the resistivity (Zr).
Fig. 12 is a graph showing the relationship between the post-annealing temperature and the resistivity (Zr).
Figs. 13(a) to (e) are sectional views for illustrating a former half portion of steps of producing a TFT panel according to a fourth embodiment.
Figs. 14(a) to (d) are sectional views for illustrating a latter half portion of the steps of producing the TFT panel according to the fourth embodiment.
Fig. 15 is an enlarged sectional view for illustrating a gate electrode and a storage capacity electrode.
Fig. 16 is a sectional view for illustrating one embodiment of a liquid crystal display device.

### EXPLANATION OF REFERENCE NUMERALS

1 --- film-forming apparatus, 2 --- first film-forming chamber (vacuum chamber), 10 --- target portion, 11 --- main target, 12 --- auxiliary target, 22, 41, 82 --- substrate, 23, 61, 86 --- silicon layer, 25, 52, 54, 93 --- electroconductive film (first and second electroconductive films), 26 --- copper film, 40, 80, 140 --- TFT panel, 60, 90, 220 --- TFT, 62, 87, 225 --- source area, 64, 89, 226 --- drain area, 71, 85transparent electrode (transparent electroconductive film)

### BEST MODE FOR CARRYING OUT THE INVENTION

The steps of forming an electroconductive film according to the present invention will be explained in detail.

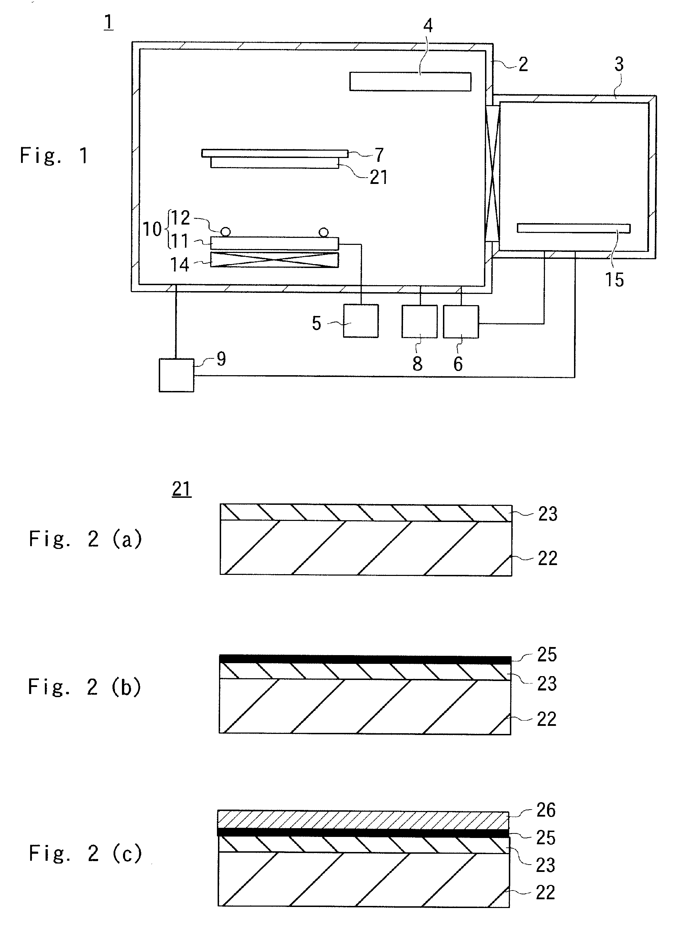

In Fig. 1, a reference numeral 1 indicates one example of a film forming apparatus to be used in the present invention. The film forming apparatus 1 has a first film forming chamber 2 with a vacuum chamber. A vacuum evacuation system 9, a sputtering gas feeding system 6 and a nitrogen gas feeding system 8 are connected to the first film forming chamber 2.

When an electroconductive film is to be formed by using this film forming apparatus 1, the inside of the first film forming chamber 2 is first evacuated to a vacuum by the vacuum evacuating system 9, a sputtering gas and a nitriding gas (a nitrogen gas and N₂ in this case) are fed into the first film forming chamber 2 from the sputtering gas feeding system 6 and the nitrogen gas feeding system 8, respectively, while the vacuum evacuation is being continued, and thereby a first vacuum atmosphere containing the nitrogen gas is formed at a predetermined pressure.

In Fig. 2(a), a reference numeral 21 indicates an object to be film-formed in which a silicon layer 23 (an amorphous silicon layer here) is formed on a surface of a substrate 22. The object 21 to be film-formed is carried into the first film forming chamber 2, while the first vacuum atmosphere is being kept by continuing the introduction of the sputtering gas and the nitrogen gas, and by continuing the vacuum evacuation.

A substrate holder 7 and a target portion 10 are arranged so as to face each other inside the first film forming chamber 2, and the object 21 to be film-formed is held by the substrate holder 7 in such a manner that a face on which the silicon layer 23 has been formed is faced toward the target portion 10. A heater 4 is arranged on a back face side of the substrate holder 7, and the object 21 on the substrate holder 7 is heated to a predetermined film-forming temperature by passing an electric current through the heater 4.

The target portion 10 comprises a main target 11 composed mainly of copper and an auxiliary target 12 (pellet) composed mainly of an addition metal (Ti in this case).

The planar shape of the main target 11 is oblong, rectangular, circular or the like in a plate-like form. The main target 11 is arranged such that one face thereof is faced toward the substrate holder 7.

The shape of the auxiliary target 12 is not particularly limited to any of a plate-like shape, a spherical shape, a rod-like shape or the like, but its planar shape is smaller than that of the main target 11. The auxiliary target 12 is placed on that face of the main target 11 which is faced toward the substrate holder 7.

The main target 11 and the auxiliary target 12 are connected to an electric power source 5 arranged outside the vacuum chamber 2.

A magnetic field-forming device 14 is arranged on a back face of the main target 11. When voltage is applied to both the main target 11 and the auxiliary target 12 from the electric power source 5 while the first vacuum atmosphere is being maintained, both the main target 11 and the auxiliary target 12 are magnetron sputtered, and sputtered particles of copper and those of the addition metal are ejected, respectively. Those sputtered particles reach the surface of the silicon layer 23 of the object 21 to be film-formed.

As described above, the planar shape of the auxiliary target 12 is smaller than that of the main target 11. Since the ejected amount of the sputtered particles of the addition metal is smaller than that of copper, the amount of the sputtered particles of the copper that reach the object 21 to be film-formed is greater than that of the addition metal. Therefore, an electroconductive film 25 composed mainly of copper and containing the addition metal grows on the surface of the silicon layer 23 (Fig. 2(b)).

A substrate (glass substrate) in which glass is exposed from a surface thereof may be used as the object to be film-formed, so that the electroconductive film 25 is grown on the surface of the glass substrate.

When the object 21 to be film-formed is kept at the above-described film-forming temperature during the growth of the electroconductive film 25, the adhesion of the electroconductive film 25 to the silicon layer 23 and the substrate 22 (the glass substrate, for example) is enhanced.

A second film forming chamber 3 constituted by a vacuum chamber is connected to the first film forming chamber 2. The vacuum evacuation system 9 and the sputtering gas feeding system 6 are connected to the second film-forming chamber 3. After the interior of the second film forming chamber 3 is evacuated to vacuum by the vacuum evacuation system 9, a second vacuum atmosphere containing no nitrogen gas is preliminarily formed inside the second film forming chamber 3 by feeding the sputtering gas from the sputtering gas feeding system 6 under the continuous vacuum evacuation.

After the electroconductive film 25 is grown to a predetermined film thickness, a part of the objects 21 to be film-formed is taken out from the film forming apparatus 1 for "Adhesion test", "Resistivity test", "Adhesion, resistivity and diffusion tests" and "Kinds of addition metals" as described later, and is carried into a heater (not shown) and heated (annealed) in the heater; and the remainder of the object 21 is carried into the second film forming chamber 3 in which the second vacuum atmosphere is being maintained.

A copper target 15 composed mainly of copper is arranged inside the second film forming chamber 3. When sputtering is performed under the application of a negative voltage to the copper target 15 in the state that the second film forming chamber 3 is set to a ground potential while the second vacuum atmosphere is being maintained, a copper film 26 composed mainly of copper grows on a surface of the electroconductive film 25 (Fig. 2(c)).

The copper target 15 contains no addition metal, and the second vacuum atmosphere contains no nitrogen gas.

The copper film, which is formed by sputtering only the copper target 15 in the second vacuum atmosphere without sputtering another target such as an auxiliary target, contains none of nitrogen and the addition metal. When pure copper (containing 99.9 at% or more of copper) is used as the copper target 15, the copper film 26 consists of pure copper.

Fig. 2(c) shows a state in which the copper film 26 is formed. The objects 21 in this state were taken out from the film forming apparatus 21, and used in the "Electrode evaluation test" as described later.

### EXAMPLES

### <Adhesion test>

A target of copper (purity: 99.9 at% or more) in a diameter of 7 inches was used as the main target 11, and a target of Ti was used as the auxiliary target 12.

While the content of Ti in an electroconductive film 25, the partial pressure of nitrogen at the time of the film formation and the heating temperature on the annealing treatment (post-annealing temperature) were changed, the electroconductive film 25 was formed on a surface of a glass substrate. Thus, 125 kinds of test pieces were prepared.

Further, 125 kinds of test pieces were prepared by forming electroconductive films 25 on surfaces of glass substrates by the same processes as described above except that the auxiliary target 12 was replaced by a target composed of Zr.

In the above, film forming conditions for each electroconductive film 25 were a desired film thickness of the electroconductive film 25: 300 nm, the sputtering gas: Ar gas and the total pressure in the interior of the first film forming chamber 2: 0.4Pa. The contents of Ti and Zr in the electroconductive films 25, the rate of the partial pressure of the nitrogen to the total pressure (the inner pressure of the vacuum chamber) and the post annealing temperature are shown in the following Tables 1 and 2.

**Table 1**

| Table 1 : Adhesion test (Addition metal : Ti) | | | | | | | |
|---|---|---|---|---|---|---|---|
| Addition element | Content [at%] | Partial pressure of N₂ added [%] | Post-annealing temperature | | | | |
| | | | as depo. | 250 | 300 | 400 | 450 |
| Ti | 0 | 0 | 0/100 | 0/100 | 0/100 | 0/100 | 0/100 |
| | | 0.1 | 4/100 | 5/100 | 4/100 | 8/100 | 9/100 |
| | | 3.0 | 29/100 | 22/100 | 35/100 | 32/100 | 37/100 |
| | | 10.0 | 41/100 | 49/100 | 51/100 | 55/100 | 57/100 |
| | | 50.0 | 68/100 | 79/100 | 77/100 | 84/100 | 81/100 |
| | 0.1 | 0 | 13/100 | 12/100 | 17/100 | 20/100 | 21/100 |
| | | 0.1 | 99/100 | 98/100 | 99/100 | 97/100 | 98/100 |
| | | 3.0 | 94/100 | 100/100 | 100/100 | 100/100 | 100/100 |
| | | 10.0 | 100/100 | 100/100 | 100/100 | 100/100 | 100/100 |
| | | 50.0 | 100/100 | 100/100 | 100/100 | 100/100 | 100/100 |
| | 3 | 0 | 20/100 | 23/100 | 25/100 | 24/100 | 27/100 |
| | | 0.1 | 99/100 | 100/100 | 100/100 | 100/100 | 100/100 |
| | | 3.0 | 100/100 | 100/100 | 100/100 | 100/100 | 100/100 |
| | | 10.0 | 100/100 | 100/100 | 100/100 | 100/100 | 100/100 |
| | | 50.0 | 100/100 | 100/100 | 100/100 | 100/100 | 100/100 |
| | 10 | 0 | 41/100 | 44/100 | 47/100 | 46/100 | 48/100 |
| | | 0.1 | 100/100 | 100/100 | 100/100 | 100/100 | 100/100 |
| | | 3.0 | 100/100 | 100/100 | 100/100 | 100/100 | 100/100 |
| | | 10.0 | 100/100 | 100/100 | 100/100 | 100/100 | 100/100 |
| | | 50.0 | 100/100 | 100/100 | 100/100 | 100/100 | 100/100 |
| | 20 | 0 | 76/100 | 79/100 | 77/100 | 75/100 | 74/100 |
| | | 0.1 | 100/100 | 100/100 | 100/100 | 100/100 | 100/100 |
| | | 3.0 | 100/100 | 100/100 | 100/100 | 100/100 | 100/100 |
| | | 10.0 | 100/100 | 100/100 | 100/100 | 100/100 | 100/100 |
| | | 50.0 | 100/100 | 100/100 | 100/100 | 100/100 | 100/100 |

**Table 2**

| Table 2 : Adhesion test (Addition metal : Zr) | | | | | | | |
|---|---|---|---|---|---|---|---|
| Addition element | Content [at%] | Partial pressure of N₂ added [%] | Post-annealing temperature | | | | |
| | | | as depo. | 250 | 300 | 400 | 450 |
| Zr | 0 | 0 | 0/100 | 0/100 | 0/100 | 0/100 | 0/100 |
| | | 0.1 | 3/100 | 2/100 | 6/100 | 9/100 | 10/100 |
| | | 3.0 | 28/100 | 23/100 | 33/100 | 34/100 | 36/100 |
| | | 10.0 | 44/100 | 50/100 | 53/100 | 56/100 | 59/100 |
| | | 50.0 | 70/100 | 72/100 | 71/100 | 80/100 | 83/100 |
| | 0.1 | 0 | 10/100 | 11/100 | 15/100 | 19/100 | 20/100 |
| | | 0.1 | 96/100 | 94/100 | 98/100 | 99/100 | 97/100 |
| | | 3.0 | 95/100 | 100/100 | 100/100 | 100/100 | 100/100 |
| | | 10.0 | 100/100 | 100/100 | 100/100 | 100/100 | 100/100 |
| | | 50.0 | 100/100 | 100/100 | 100/100 | 100/100 | 100/100 |
| | 3 | 0 | 23/100 | 25/100 | 29/100 | 28/100 | 30/100 |
| | | 0.1 | 99/100 | 100/100 | 100/100 | 100/100 | 100/100 |
| | | 3.0 | 100/100 | 100/100 | 100/100 | 100/100 | 100/100 |
| | | 10.0 | 100/100 | 100/100 | 100/100 | 100/100 | 100/100 |
| | | 50.0 | 100/100 | 100/100 | 100/100 | 100/100 | 100/100 |
| | 10 | 0 | 45/100 | 47/100 | 51/100 | 49/100 | 50/100 |
| | | 0.1 | 100/100 | 100/100 | 100/100 | 100/100 | 100/100 |
| | | 3.0 | 100/100 | 100/100 | 100/100 | 100/100 | 100/100 |
| | | 10.0 | 100/100 | 100/100 | 100/100 | 100/100 | 100/100 |
| | | 50.0 | 100/100 | 100/100 | 100/100 | 100/100 | 100/100 |
| | 20 | 0 | 78/100 | 75/100 | 74/100 | 76/100 | 77/100 |
| | | 0.1 | 100/100 | 100/100 | 100/100 | 100/100 | 100/100 |
| | | 3.0 | 100/100 | 100/100 | 100/100 | 100/100 | 100/100 |
| | | 10.0 | 100/100 | 100/100 | 100/100 | 100/100 | 100/100 |
| | | 50.0 | 100/100 | 100/100 | 100/100 | 100/100 | 100/100 |

In the above Tables 1 and 2, "as depo." means a case where no heating was performed after the formation of the electroconductive film 25. Further, in the cases where Ti was zero and Zr was zero, only the main target was sputtered without the auxiliary target being placed on the main target. With respect to the obtained electroconductive films 25, "adhesion" was examined under the following condition.

### [Adhesion]

A total of 100 of 1mm grid squares were inscribed in 10 lines x 10 columns on a face of the electroconductive film 25 formed on the object 21 to be film-formed by using a sharp-edged cutter knife, and an adhesive tape (No. 610 Scotch tape) was stuck thereto. Thereafter, evaluation was performed by the remaining number of the films when the adhesive tape was peeled. When all the grid squares were peeled, the evaluation was 0/100, whereas when none was peeled because of high adhesion, the evaluation was 100/100. Thus, the greater the number of the numerator, the higher is the adhesion. Results thereof are shown in the above Tables 1 and 2.

As clearly shown in the above Tables 1 and 2, in the case where no nitrogen gas was introduced at the time of the film formation, a part of the electroconductive film was peeled even when the content of Ti or Zr was as much as 20 at% (atomic %). On the other hand, in the case where the nitrogen gas was introduced in an amount of 0.1% or more relative to the total pressure at the time of the film formation, the electroconductive film 25 was almost not peeled when the content of Ti or Zr was as low as 0.1 at%.

In addition, the adhesion is enhanced by increasing the introduced amount of the nitrogen gas without containing Ti or Zr. However, even if the introduced amount of the nitrogen gas corresponds to as much as 50% of the total pressure, the peeling of the electroconductive film can be prevented by 70 to 80% only. It turns out that having both the addition metal (such as Ti or Zr) in the electroconductive film 25 and the introduction of the nitrogen gas at the time of the film formation are required in order to attain sufficient adhesion.

On the other, examination of the film-forming temperature at the time of the formation of the electroconductive film 25 revealed that the adhesion was significantly enhanced at the film forming temperature of 120°C or more as compared to a case with no heating at the time of the film formation.

### <Resistivity test>

Electroconductive films 25 containing 0 at% of an addition metal (pure copper) and those containing 0.5 at% of Ti or 0.5 at% of Zr were formed on surfaces of glass substrates, in a state where the introduced amount of nitrogen was changed.

Here, the film forming conditions were the same as in the case of the above "Adhesion test" except that the post annealing temperatures were all set at 350°C. Resistivies of the obtained electroconductive films 25 were measured.

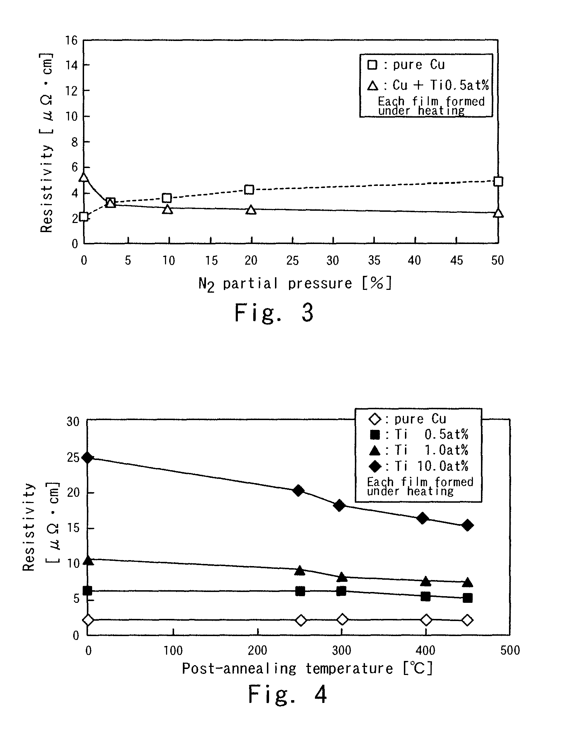

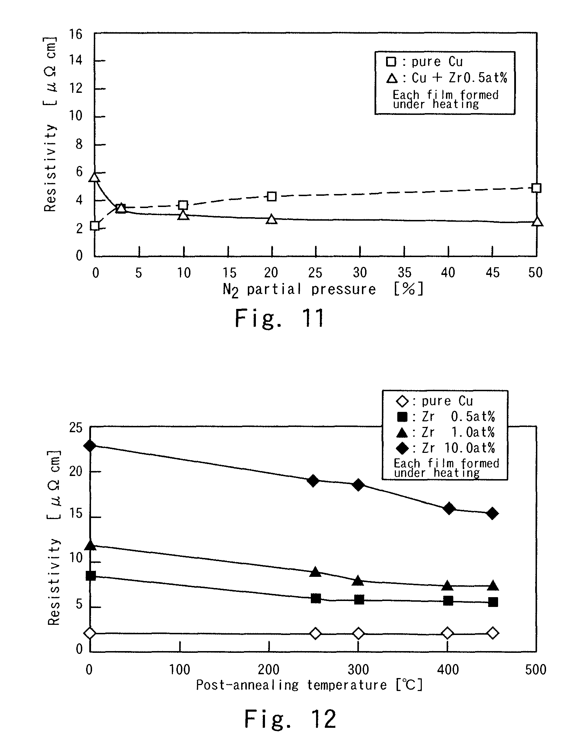

Measurement results thereof are shown in Fig. 3 and Fig. 11. In Fig. 3 and Fig. 11, the abscissa shows a rate of the nitrogen partial pressure to the total pressure inside the vacuum chamber, and the ordinate shows the resistivity.

As is clear from Fig. 3 and Fig. 11, as to the electroconductive films (copper films) formed without the addition metal such as Ti or Zr, the greater the introduction amount of the nitrogen gas, the greater was the resistivity. To the contrary, in the case of the electroconductive films 25 containing the addition metal (alloy films), although the resistivity was higher than that of the copper film when the introduced amount of the nitrogen gas was zero, the resistivity decreased, as the introduced amount of the nitrogen gas increased. When the partial pressure of the nitrogen gas at the time of the film formation was 3%, the resistivities were almost equal, whereas the resistivity was lower than that of the copper film when the partial pressure of the nitrogen gas was 10%.

Since the addition metal such as Ti or Zr has a property of not forming a solid solution with Cu and in addition Cu does not react with N₂, the addition metal and a nitride as a reaction product with N₂ positively separate from Cu. As a result, the resistivity of the electroconductive film containing the addition metal is more reduced as compared to the electroconductive film using Cu alone.

As described above, the electroconductive films 25, into which the addition metal such as Ti or Zr was incorporated while the nitrogen gas was introduced at the time of the film formation, have high adhesion to the objects to be film-formed, such as glass substrates or silicon layers, as compared to the electroconductive films formed while no nitrogen gas was introduced at the time of the film formation. Therefore, the resulting electroconductive film 25 according to the present invention has both adhesion and a low resistance value.

As a reference, test pieces were prepared by forming electroconductive films without the introduction of nitrogen at the time of the film formation, while the content of the addition metal and the post annealing temperature were changed respectively, and the resistivities of the electroconductive films were measured. Fig. 4 shows measurement results when the addition metal was Ti, and Fig. 12 shows measurement results when the addition metal was Zr.

As is clear from Fig. 4 and Fig. 12, the resistivity was decreased by annealing after the formation of the electroconductive film, and there was a tendency that the electroconductive film into which the addition metal was incorporated decreased with the increase in the post-annealing temperature.

It is considered that since the addition metal such as Zr or Ti has the property of not forming a solid solution with Cu, the post annealing precipitated the addition metal, and thus made the resistance value approach that of Cu alone. Furthermore, when the electroconductive film is heated to a predetermined film forming temperature (for example, 120°C or more) at the time of the film formation, the resistivity is decreased at a temperature lower than the post-annealing temperature.

### <Adhesion, resistivity, diffusion test>

Glass substrates and silicon substrates were used as objects to be film-formed, and test pieces were obtained by forming electroconductive films on surfaces of the glass substrates and that of silicon layers (Si layers) of the silicon substrates.

Here, the film forming conditions of the electroconductive films 25 were the same as in the case where the "post-annealing temperature" was 450°C in the above "Adhesion test", except that the film thickness was changed to 350nm.

With respect to the test pieces having the electroconductive films on the surfaces of the glass substrates, the above "Adhesion test" and the measurement of the resistivity of the electroconductive film 25 were carried out. With respect to the test pieces in which the electroconductive films were formed on the surfaces of the Si layers, it was confirmed whether copper diffused into the Si layers or not. In this case, whether copper diffused into the Si layers or not was confirmed by observing the surfaces of the Si layers with an electron microscope after the electroconductive films 25 were removed by etching.

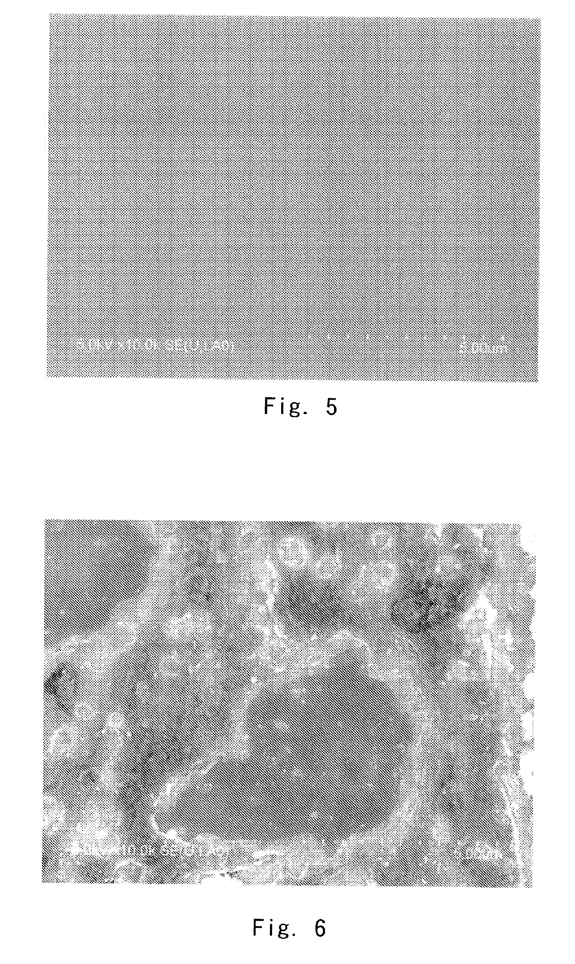

In the following Tables 3 and 4, measurement results of "Adhesion test" and "Resistivity" and results as to whether copper diffused or not are shown. Fig. 5 shows an electron microscope photograph of a surface of a Si layer formed under the conditions that Ti was used as the addition metal, the content of Ti was 3 at% and the partial pressure of nitrogen was 3%. Fig. 6 shows an electron microscope photograph of a surface of a Si layer formed under the conditions that the content of Ti was zero and the partial pressure of nitrogen was 0% at the time of the film formation.

**Table 3**

| Table 3 : Adhesion,resistivity and diffusion test (Addition metal : Ti) | | | | | |
|---|---|---|---|---|---|
| | | | Each film thickness : 350nm | | |
| Addition element | Content [at%] | Partial pressure of N₂ added [%] | After annealing at 450°C | | |
| | | | Resistivity [µΩ cm] | Adhesion | Diffusion into Si |
| Ti | 0 | 0 | 2.1 | 0/100 | Diffused |
| | | 0.1 | 2.5 | 9/100 | Diffused |
| | | 3.0 | 3.0 | 37/100 | Diffused |
| | | 10.0 | 3.8 | 57/100 | Diffused |
| | | 50.0 | 4.8 | 81/100 | Diffused |
| | 0.1 | 0 | 4.5 | 21/100 | Not diffused |
| | | 0.1 | 4.3 | 98/100 | Not diffused |
| | | 3.0 | 3.2 | 100/100 | Not diffused |
| | | 10.0 | 3.1 | 100/100 | Not diffused |
| | | 50.0 | 2.5 | 100/100 | Not diffused |
| | 3 | 0 | 5.3 | 27/100 | Not diffused |
| | | 0.1 | 5.0 | 100/100 | Not diffused |
| | | 3.0 | 3.5 | 100/100 | Not diffused |
| | | 10.0 | 3.4 | 100/100 | Not diffused |
| | | 50.0 | 2.8 | 100/100 | Not diffused |
| | 10 | 0 | 7.3 | 48/100 | Not diffused |
| | | 0.1 | 6.8 | 100/100 | Not diffused |
| | | 3.0 | 3.9 | 100/100 | Not diffused |
| | | 10.0 | 3.6 | 100/100 | Not diffused |
| | | 50.0 | 3.2 | 100/100 | Not diffused |
| | 20 | 0 | 15.0 | 74/100 | Not diffused |
| | | 0.1 | 13.0 | 100/100 | Not diffused |
| | | 3.0 | 4.0 | 100/100 | Not diffused |
| | | 10.0 | 3.8 | 100/100 | Not diffused |
| | | 50.0 | 3.3 | 100/100 | Not diffused |

**Table 4**

| Table 4 : Adhesion, resistivity, diffusion test (Addition metal : Zr) | | | | | |
|---|---|---|---|---|---|
| | | | Each film thickness : 350nm | | |
| Addition element | Content [at%] | Partial pressure of N₂ added [%] | After annealing at 450°C | | |
| | | | Resistivity [µΩ cm] | Adhesion | Diffusion into Si |
| Zr | 0 | 0 | 2.1 | 0/100 | Diffused |
| | | 0.1 | 2.5 | 9/100 | Diffused |
| | | 3.0 | 3.0 | 37/100 | Diffused |
| | | 10.0 | 3.8 | 57/100 | Diffused |
| | | 50.0 | 4.8 | 81/100 | Diffused |
| | 0.1 | 0 | 4.6 | 19/100 | Not diffused |
| | | 0.1 | 4.2 | 98/100 | Not diffused |
| | | 3.0 | 3.3 | 100/100 | Not diffused |
| | | 10.0 | 3.0 | 100/100 | Not diffused |
| | | 50.0 | 2.6 | 100/100 | Not diffused |
| | 3 | 0 | 5.1 | 30/100 | Not diffused |
| | | 0.1 | 4.9 | 100/100 | Not diffused |
| | | 3.0 | 3.7 | 100/100 | Not diffused |
| | | 10.0 | 3.3 | 100/100 | Not diffused |
| | | 50.0 | 2.5 | 100/100 | Not diffused |
| | 10 | 0 | 15.0 | 65/100 | Not diffused |
| | | 0.1 | 6.9 | 100/100 | Not diffused |
| | | 3.0 | 4.2 | 100/100 | Not diffused |
| | | 10.0 | 4.0 | 100/100 | Not diffused |
| | | 50.0 | 3.5 | 100/100 | Not diffused |
| | 20 | 0 | 15.5 | 76/100 | Not diffused |
| | | 0.1 | 9.8 | 100/100 | Not diffused |
| | | 3.0 | 4.8 | 100/100 | Not diffused |
| | | 10.0 | 3.9 | 100/100 | Not diffused |
| | | 50.0 | 3.6 | 100/100 | Not diffused |

As is clear from the above Tables 3 and 4 and Figs. 5 and 6, copper diffused into the silicon layer when the content of the addition metal such as Ti or Zr was zero and the partial pressure of nitrogen was 0%. When the addition metal was contained by 0.1 at% or more, the surface was kept clear without diffusion of copper into the silicon layer. It is considered that the addition metal or the nitride of the addition metal (TiN, ZrN) separated in the electroconductive film 25 functions as a barrier against the reaction between Cu and Si.

Moreover, it was confirmed that, regarding the adhesion to the silicon layer, approximately 100% of the electroconductive film 25 is free from peeling when the content of the addition metal in the electroconductive film 25 is 0.1 at% or more and the partial pressure of the nitrogen gas to the total pressure of the vacuum atmosphere is 0.1% or more. As the content of the addition metal increases, the resistivity tends to become higher. When the nitrogen gas was introduced so as to become 3% or more of the total pressure at the time of the film formation, however, the resistivity decreased to the same level (as in the case of the electroconductive film into which no addition metal was incorporated) when the content of the addition metal was as much as 20%.

Consequently, based on the above case, the electroconductive films 25, which were obtained when 0.1 at% or more of the addition metal was incorporated and the nitrogen gas was introduced so as to become 0.3% or more of the total pressure at the time of the film formation, not only have excellent adhesion but also have the resistivity at the same level as that of the pure copper film; and additionally, the electroconductive films 25 prevent copper from diffusing into the silicon layer.

As described above, as the introduction amount of the nitrogen gas increases, the resistivity tends to decrease. When the introduced amount of the nitrogen gas is set to become over 50% of the total pressure of the first vacuum atmosphere and the introduced amount of the sputtered gas is set to become less than 50% of the total pressure, the sputtering speed significantly drops and the film forming efficiency deteriorates. Therefore, the upper limit of the introduced amount of the nitrogen gas is preferably set at 50% or less of the total pressure in the first vacuum atmosphere.

### <Electrode evaluation test>

Electroconductive films 25 were formed in the case where the introduction amount of the nitrogen gas was set to become 3% of the total pressure and the contents of an addition metal (Ti, Zr) were 0.1 at%, 3 at% and 10 at%, respectively. In this case, glass substrates and silicon substrates were used as objects to be film-formed. The film forming conditions for the electroconductive films 25 were the same as in the above "Adhesion, resistivity, diffusion test", except that the film thickness was changed to 50nm.

A copper film 26 was further formed in a film thickness of 300nm on a surface of the electroconductive film 25, thereby preparing a test piece in which the electroconductive film 25 and the copper film 26 were laminated. In the above case, the copper film 26 was formed by sputtering a copper target (a pure copper target) without introducing the nitrogen gas inside the second film forming chamber 3.

With respect to the test pieces having the glass substrates as the objects to be film-formed, "resistivity" and "adhesion" were measured, whereas "diffusion property into Si" was measured with respect to the test pieces having the silicon substrates as the objects to be film-formed.

Measurement results thereof are shown in columns "Cu/Cu-Ti" in the following Tables 5 and 6. Among the measurement results in the above Tables 3 and 4, those in which the introduced amount of the nitrogen gas was set at 3% of the total pressure and the contents of the addition metal were 0 at%, 0.1 at%, 3 at% and 10 at%, respectively were shown in a column "Cu" and a column "Cu-Ti" of Tables 5 and 6.

**Table 5**

| Table 5 : Electrode evaluation test (Addition metal : Ti) | | | | | |
|---|---|---|---|---|---|
| | | | Total film thickness : 350nm | | |
| Film construction | Content [at%] | Partial pressure of N₂ added [%] | After annealing at 450°C | | |
| | | | Resistivity [µΩ cm] | Adhesion | Diffusion into Si |
| Cu | 0 | 0 | 2.1 | 0/100 | Diffused |
| Cu-Ti | 0.1 | 3.0 | 3.2 | 100/100 | Not diffused |
| | 3 | 3.0 | 3.5 | 100/100 | Not diffused |
| | 10 | 3.0 | 3.9 | 100/100 | Not diffused |
| Cu/Cu-Ti* | 0.1 | 3.0 | 2.1 | 100/100 | Not diffused |
| | 3 | 3.0 | 2.2 | 100/100 | Not diffused |
| | 10 | 3.0 | 2.1 | 100/100 | Not diffused |

| | | | | | |
|---|---|---|---|---|---|
| * No nitrogen added at the time of Cu film formation | | | | | |

**Table 6**

| Table 6 : Electrode evaluation test (Addition metal : Zr) | | | | | |
|---|---|---|---|---|---|
| | | | Total film thickness 350nm | | |
| Film construction | Content [at%] | Partial pressure of N₂ added [%] | After annealing at 450°C | | |
| | | | Resistivity [µΩ cm] | Adhesion | Diffusion into Si |
| Cu | 0 | 0 | 2.1 | 0/100 | Diffused |
| Cu-Zr | 0.1 | 3.0 | 3.3 | 100/100 | Not diffused |
| | 3 | 3.0 | 3.7 | 100/100 | Not diffused |
| | 10 | 3.0 | 4.2 | 100/100 | Not diffused |
| Cu/Cu-Zr* | 0.1 | 3.0 | 2.2 | 100/100 | Not diffused |
| | 3 | 3.0 | 2.1 | 100/100 | Not diffused |
| | 10 | 3.0 | 2.1 | 100/100 | Not diffused |

| | | | | | |
|---|---|---|---|---|---|
| * No nitrogen added at the time of Cu film formation | | | | | |

As is clear from the above Tables 5 and 6, the laminated films in which the copper film 26 was laminated on the surface of the electroconductive film 25 was low in terms of resistivity at the same level as that of the copper film alone, as well as adhesion and excellent diffusion preventing property against Si as in the case of the electroconductive film 25 alone.

Consequently, based on the above case, the laminated film, in which the copper film (containing no addition metal and prepared without introducing nitrogen gas) was formed on the electroconductive film 25 formed by the film forming method according to the present invention, is excellent particularly as an electrode that tightly adhere to the glass substrate or the silicon layer.

### <Contact resistance to ITO>

Among the test pieces formed in the above "Adhesion, resistivity, diffusion test", the glass substrates were used as the objects to be film-formed, the test pieces were prepared, in which the introduced amount of the nitrogen gas at the time of the film formation was set to become 3% of the total pressure and the contents of the addition metal (Ti, Zr) in the electroconductive films 25 were 0.1 at%, 3 at% and 10 at%, respectively. An ITO thin film was formed in a film thickness of 150nm on a surface of the electroconductive film 25 of each test piece.

The ITO thin films were formed under the same conditions as in the above six kinds of the test pieces, except that test pieces formed with an Al film or a copper film instead of the above electroconductive films 25 were used. In the above case, the copper film was formed by sputtering a pure copper target without the introduction of nitrogen gas.

With respect to the test pieces in which the ITO thin film was formed, contact resistances between the ITO film and the non-annealed electroconductive film 25 (as depo.) and between the ITO film and the electroconductive films 25 annealed at 250°C were measured. Measurement results thereof are shown in the following Tables 7 and 8.

**Table 7**

| Table 7 : Contact resistance (Addition metal : Ti) | | | | |
|---|---|---|---|---|
| | | Film thickness of IT0 : 150nm | | |
| Film construction | Ti Content [at%] | Partial pressure of N₂ added [%] | Contact resistance [ Ω ] | |
| | | | as depo. | After annealing at 250°C |
| ITO/Al/glass | - | - | 138.5 | 441.9 |
| ITO/Cu/glass | - | - | 5.8 | 29.0 |
| ITO/Cu-Ti/glass | 0.1 | 3.0 | 5.8 | 30.1 |
| | 3.0 | 3.0 | 5.6 | 28.8 |
| | 10.0 | 3.0 | 6.1 | 29.2 |

**Table 8**

| Table 8 : Contact resistance (Addition metal : Zr) | | | | |
|---|---|---|---|---|
| | | Film thickness of IT0 : 150nm | | |
| Film construction | Ti content [at%] | Partial pressure of N₂ added [%] | Contact resistance [ Ω ] | |
| | | | as depo. | After annealing at 250°C |
| ITO/Al/glass | - | - | 139.5 | 441.9 |
| ITO/Cu/glass | - | - | 5.8 | 29.0 |
| ITO/Cu-Zr/glass | 0.1 | 3.0 | 5.7 | 29.5 |
| | 3.0 | 3.0 | 5.4 | 30.2 |
| | 10.0 | 3.0 | 5.9 | 29.1 |

As is clear from the above Tables 7 and 8, the Al films exhibited high contact resistances, and the contact resistance was so high particularly after the annealing treatment that the electroconductive film could not be used for a TFT. To the contrary, the electroconductive films 25 formed in the present application was low in the contact resistances at the same levels as those of the copper film, and increases in the contact resistances after the annealing treatment were small.

Therefore, it turns out that the electroconductive film 25 formed by the present invention not only has adhesion to the Si layer and the glass substrate and excellent resistivity as described above but also excellent diffusion-preventing property for the Si layer. In addition, the electroconductive film exhibits a low constant resistance value to the transparent electrode such as ITO, and thus is excellent as an electrode to be tightly adhered to the ITO.

### <Kinds of the addition metals>

Next, electroconductive films 25 (alloy films) each containing 1 at% of an addition metal were prepared by sputtering under the same conditions as in the above "Adhesion test", except that each of addition metals shown in the following Table 9 was used as an auxiliary target in place of Ti and Zr. The kinds of the addition elements and the partial pressure of nitrogen in the vacuum chamber at the time of sputtering are shown in the following Table 9.

**Table 9**

| Table 9 : Kinds of addition metals | | | | | |
|---|---|---|---|---|---|
| Addition element [each 1at%] | Addition gas Partial pressure of N₂ [%] | After annealing at 350°C | | After annealing at 450°C | |
| | | Resistivity | Adhesion | Resistivity | Adhesion |
| - | - | 2.0 | 0/100 | 2.0 | 0/100 |
| Ag | 1 | 2.7 | 100/100 | 2.7 | 100/100 |
| B | 0.1 | 3.1 | 100/100 | 2.9 | 100/100 |
| Bi | 5 | 4.8 | 100/100 | 4.3 | 100/100 |
| C | 50 | 4.2 | 100/100 | 3.9 | 100/100 |
| Ce | 3 | 4.4 | 100/100 | 4.3 | 100/100 |
| Ce | 0 | 8.8 | 54/100 | 8.7 | 53/100 |
| Co | 25 | 4.1 | 100/100 | 4.1 | 100/100 |
| Cr | 0.5 | 3.9 | 100/100 | 3.8 | 100/100 |
| Fe | 3 | 4.6 | 100/100 | 4.5 | 100/100 |
| Hf | 1 | 3.3 | 100/100 | 3.2 | 100/100 |
| Hf | 0 | 9.9 | 57/100 | 9.8 | 52/100 |
| Nb | 5 | 4.2 | 100/100 | 4.0 | 100/100 |
| Nb | 0 | 7.5 | 63/100 | 7.3 | 65/100 |
| Os | 0.1 | 4.7 | 100/100 | 4.6 | 100/100 |
| Ru | 5 | 3.8 | 100/100 | 3.5 | 100/100 |
| Sn | 25 | 3.6 | 100/100 | 3.6 | 100/100 |
| Ta | 50 | 3.9 | 100/100 | 3.5 | 100/100 |
| Ta | 0 | 7.6 | 55/100 | 7.4 | 52/100 |
| Mo | 25 | 3.7 | 100/100 | 3.4 | 100/100 |
| Mn | 1 | 3.1 | 100/100 | 3.0 | 100/100 |
| Ni | 0.1 | 3.3 | 100/100 | 3.3 | 100/100 |
| V | 10 | 4.1 | 100/100 | 4.1 | 100/100 |
| V | 0 | 7.9 | 63/100 | 7.5 | 64/100 |
| W | 1 | 4.7 | 100/100 | 4.2 | 100/100 |
| Zn | 0.5 | 4.9 | 100/100 | 4.8 | 100/100 |
| Zn | 0 | 6.8 | 55/100 | 6.5 | 57/100 |

| | | | | | |
|---|---|---|---|---|---|
| Unit of resistivity: µΩ · cm | | | | | |

By heating substrates on which the alloy films were formed at post-annealing temperatures of 350°C and 450°C, respectively, test pieces were prepared, and, with respect to the alloy film of each of the test pieces, measurement of the resistivity and the adhesion test were performed. Results thereof were shown in the above Table 9.

As is clear from the above Table 9, the alloy film using each of the addition metals enhanced the adhesion when the nitrogen gas was contained as compared to cases where no nitrogen gas was contained at the time of sputtering (the partial pressure of the nitrogen gas 0%).

From the above results, it was confirmed that besides Ti and Zr, Hf, V, Nb, Ta, Cr, Mo, W, Mn, Fe, Ru, Os, Co, Ni, Bi, Ag, Zn, Sn, B, C, Al, Si, La, Ce, Pr and Nd can be used as the addition metals.

Next, one embodiment of the TFT (thin film transistor) according to the present invention will be explained.

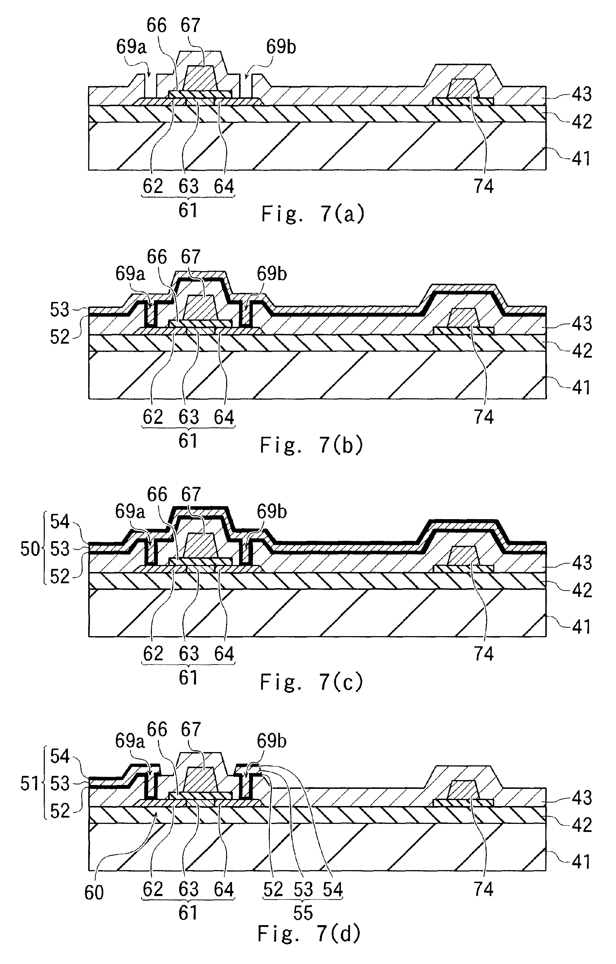

In Fig. 7(a), a reference numeral 41 indicates a transparent substrate having an insulating layer (for example, a SiO₂ layer) 42 on a surface, and a silicone layer 61 composed mainly of Si and added with a dopant is arranged at a predetermined area on a surface of the insulating layer 42.

A source area 62 and a drain area 64 are formed on the silicon layer 61, and a channel area 63 is formed between the source area 62 and the drain area 64.

A gate oxide film 66 is formed on the surface of the silicon layer 61 over the source area 62, the channel area 63 and the drain area 64, and a gate electrode 67 is disposed on the surface of the gate oxide film 66.

The face of the insulating layer 42 on which the gate electrode 67 is arranged is covered with a first interlayer insulating film 43. With respect to the first interlayer insulating film 43, a first through-hole 69a and a second through-hole 69b are formed in such a manner that the portion of the source area 62 protruding from the gate oxide film 66 is exposed at a bottom face of the first through-hole 69a and the portion of the drain area 64 protruding from the gate oxide film 66 is exposed at a bottom face of the second through-hole 69b. The first interlayer insulating film 43 is formed with a first through-hole 69a and a second through-hole 69b in such a manner that the portion of the source area 62 protruding from the gate oxide film 66 is exposed at a bottom face of the first through-hole 69a, whereas the portion of the drain area 64 protruding from the gate oxide film 66 is exposed at a bottom face of the second through-hole 69b.

The transparent substrate 41 in this state is carried in the film forming apparatus 1 shown in Fig. 1 as an object to be film-formed, a first electroconductive film is formed, by the step shown in Fig. 2(b), on the face on which the first interlayer insulating film 43 is formed; and further, a copper film is formed on the surface of the first electroconductive film by the step shown in Fig. 2(c).

Fig. 7(b) shows a state in which the first electroconductive film 52 and the copper film 53 are formed. The first electroconductive film 52 is tightly adhered to the surface of the first interlayer insulating film 43 and the inner wall faces and the bottom faces of the first and second through-holes 69a and 69b. Therefore, the first electroconductive film 52 is tightly adhered to the surface of the source area 62 and that of the drain area 64 at the bottom faces of the first and second through-holes 69a, 69b, respectively. In addition, in this state, the interiors of the first and second through-holes 69a, 69b are filled with the first electroconductive film 52 and the copper film 53.

The transparent substrate 41 in this state is returned from the second film forming chamber 3 to the first film forming chamber 2; and a second electroconductive film 54 is formed on the surface of the copper film 53 by the same method as that of forming the first electroconductive film 52 on the surface of the first interlayer insulating film 43 (Fig. 7(c)).

In Fig. 7(c), a reference numeral 50 indicates an electroconductive body consisting of the first and second electroconductive films 52, 54 and the copper film 53. When the copper film 53 is laminated together with the first and second electroconductive films 52, 54, the resistance of the entire electroconductive body 50 can be reduced.

Next, this electroconductive body 50 is patterned to separate a portion filled in the first through-hole 69a of the electroconductive body 50 from a portion filled in the second through-hole 69b of the electroconductive body 50.

In Fig. 7(d), a reference numeral 51 indicates a source electrode constituted by the portion filled in the first through-hole 69a of the electroconductive body 50 and a portion remaining therearound, and a reference numeral 55 in the same figure indicates a drain electrode constituted by the portion filled in the second through-hole 69b of the electroconductive body 50 and a portion remaining therearound. The source electrode 51 and the drain electrode 55 are separated from each other by the above-described patterning.

As described above, since the first electroconductive film 52 tightly adheres to the source area 62 and the drain area 64 at the bottom faces of the first and second through-holes 69a, 69b, the first electroconductive film 52 of the source electrode 51 is connected to the source area 62; and the first electroconductive film 52 of the drain electrode 55 is connected to the drain area 64.

Since the copper film 53 and the second electroconductive film 54 are electrically connected to the first electroconductive film 52, the copper film 53 and the second electroconductive film 54 of the source electrode 51 are electrically connected to the source area 62 via the first electroconductive film 52. The copper film 53 and the second electroconductive film 54 of the drain electrode 55 are electrically connected to the drain area 64 via the first electroconductive film 52. Therefore, the entire source electrode 51 is electrically connected to the source area 62, and the entire drain electrode 55 is electrically connected to the drain area 64.

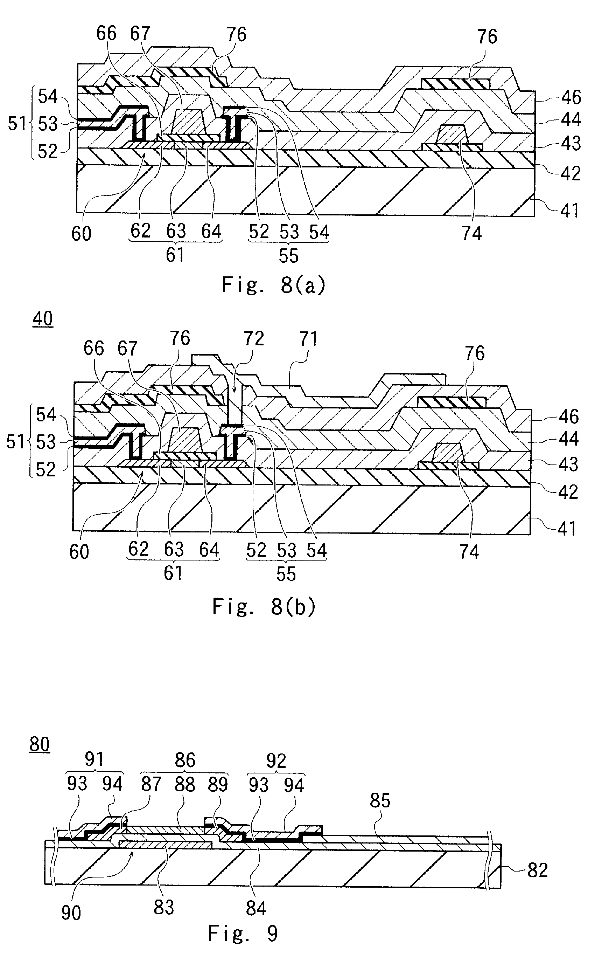

Next, a second interlayer insulating film 44 is formed on that face of the transparent substrate 41 on a side of which the source electrode 51 and the drain electrode 55 are formed. Shield films 76 are disposed at the predetermined positions of the surface of the second interlayer insulating film 44. Thereafter, a third interlayer insulating layer 46 is formed on that face of the second interlayer insulating film 44 on a side of which the shielding film 76 is arranged (Fig. 8(a)).

Next, a third through-hole 72, which communicates with the second and third interlayer insulating films 44, 46, is formed at a position immediately above the drain electrode 55; and the second electroconductive film 54 of the drain electrode 55 is exposed to the bottom face of the third through-hole 72. Thereafter, an ITO transparent electroconductive film is formed, by sputtering or the like, on that face on a side of which the third through-hole 72 is formed; and the transparent electroconductive film is patterned, so that a transparent electrode 71 is constituted by a transparent electroconductive film filled in the third through-hole 72 and the transparent electroconductive film remaining above the third through-hole 72 and therearound (Fig. 8(b)).

In Fig. 8(b), reference numeral 40 indicates a TFT panel (thin film transistor-provided panel) in a state that the transparent electrode 71 is formed.

As described above, since the surface of the second electroconductive film 54 of the drain electrode 55 is positioned at the bottom face of the third through-hole 72, the transparent electrode 71 is electrically connected to the second electroconductive film 54 of the drain electrode 55.

Therefore, the copper film 53 of the drain electrode 55 and the first electroconductive film 52 are electrically connected to the transparent electrode 71 via the second electroconductive film 54; the entire drain electrode 55 is electrically connected to the transparent electrode 71; and the transparent electrode 71 and the drain area 64 are electrically connected via the drain electrode 55.

The source electrode 51 is connected to a source wiring (not shown). When a voltage is applied to the gate electrode 67 in a state that a voltage is applied between the source electrode 51 and the drain electrode 55, electric current flows through the channel area 63 between the source area 62 and the drain area 64. The transparent electrode 71 is connected to the source electrode 51 via the drain electrode 55, the drain area 64, the channel area 63 and the source area 62.

Since the first and second electroconductive films 52, 54 formed by the present invention have high adhesion to Si, the source electrode 51 and the drain electrode 55 are hardly peeled from the silicon layer 61. In addition, since the first and second electroconductive films 52, 54 have high diffusion-preventing property, the component metal (Cu) of the copper film 53 does not diffuse into the silicon layer 61.

Further, since the first and second electroconductive films 52, 54 formed by the present invention have low resistivities as well as a low contact resistance against the transparent electroconductive film, the source electrode 51 and the drain electrode 55 of the TFT 60 exhibit excellent conductivity.

Accordingly, the electroconductive film formed by the present invention is suitable as a barrier film for the electrode tightly adhering to the silicon layer 61 and the transparent electrode 71.

Additionally, wirings such as a gate wiring film, a source wiring film or the like, and other electric parts are arranged at a position away from the TFT 60 on the surface of the transparent substrate 41 of the TFT panel 40. Here, the gate wiring film 74 is shown.

The above explanation is provided for a case in which the first and second electroconductive films are arranged on the front faces and the rear faces of the source electrode 51 and the drain electrode 55, respectively, but the present invention is not limited thereto.

In Fig. 9, a reference numeral 80 indicates a second embodiment of a TFT panel produced by the present invention. This TFT panel 80 comprises a transparent substrate 82 and a TFT 90 arranged on a surface of the transparent substrate 82.

A gate electrode 83 of this TFT 90 is arranged on a surface of the transparent substrate 82; and an insulating film 84, which covers the surface and the side face of the gate electrode 83, is formed on that face of the transparent substrate 82 on which the gate electrode 83 is arranged. A silicon layer 86 is arranged on the gate electrode 83 of the surface of the insulating film 84; and a transparent electrode 85 made of a transparent electroconductive film is arranged at a position apart from the silicon layer 86 on the surface of the insulating film 84.

Similar to the silicon layer 61 shown in Fig. 8(b), a source area 87, a channel area 88 and a drain area 89 are formed in the silicon layer 86. A bottom face of a source electrode 91 is tightly adhered to a surface of the source area 87; and a bottom face of a drain electrode 92 is tightly adhered to a surface of the drain area 89. A part of the drain electrode 92 is extended up to the transparent electrode 85, and its bottom face is tightly adhered to a surface of the transparent electrode 85. Therefore, the bottom face of the drain electrode 92 is tightly adhered to both the drain area 89 and the transparent electrode 85.

The source electrode 91 and the drain electrode 92 comprise an electroconductive film 93 formed by the forming method of the present invention, and a copper film 94 arranged on the surface of the electroconductive film 93.

The source electrode 91 and the drain electrode 92 are formed by, for example, using the transparent substrate 82 with the transparent electrode 85 and the silicon layer 86 exposed on the surface thereof as an object to be film-formed, forming an electroconductive film over the entire surface of the object at which the transparent electrode 85 and the silicon layer 86 are exposed, forming a copper film on the surface of the electroconductive film, and thereafter patterning the electroconductive film and the copper film together.

The electroconductive film 93 is located in the bottom faces of the drain electrode 92 and the source electrode 91, respectively. Since the bottom face of the drain electrode 92 is tightly adhered to both the drain area 89 and the transparent electrode 85 as mentioned above, the electroconductive film 93 of the drain electrode 92 is electrically connected to both the transparent electrode 85 and the drain area 89.

Since the copper film 94 is tightly adhered to the electroconductive film 93, the copper film 94 of the drain electrode 92 is electrically connected to both the transparent electrode 85 and the drain area 89 via the electroconductive film 93, and the entire drain electrode 92 is electrically connected to both the drain area 89 and the transparent electrode 85.

Further, since the bottom face of the source electrode 91 is tightly adhered to the source area 87, the electroconductive film 93 of the source electrode 91 is electrically connected to the source area 87; the copper film 94 of the source electrode 91 is electrically connected to the source area 87 via the electroconductive film 93; and the entire source electrode 91 is electrically connected to the source area 87.

Since the electroconductive film 93 formed by the present invention has a low contact resistance to ITO as described above, conductivity is excellent between the drain electrode 92 and the transparent electrode 85.

In this TFT panel 80, the source electrode 91 is connected to a source wiring (not shown). When a voltage is applied to the gate electrode 83 in a state that a voltage is applied between the source electrode 91 and the drain electrode 92, electric current flows between the source area 87 and the drain area 89 via the channel area 88. The transparent electrode 85 is connected to the source electrode 91 via the source area 87, the channel area 88, the drain area 89 and the drain electrode 92.

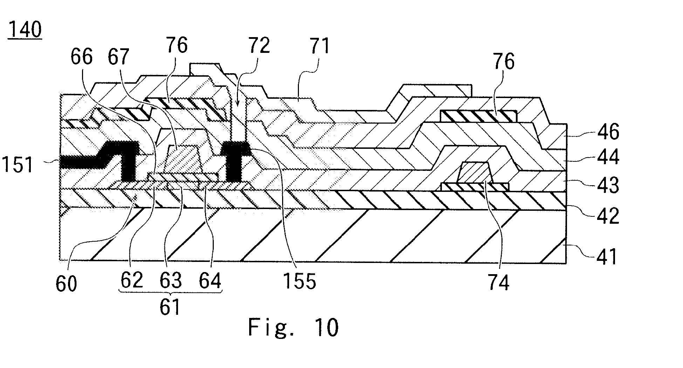

The above explanation has been made for a case where the source electrode and the drain electrode are constituted by the electroconductive film and the copper film, but the present invention is not limited thereto. In Fig. 10, a reference numeral 140 indicates a TFT panel of a third embodiment of the present invention. This TFT panel 140 has the same construction as the TFT panel 40 shown in the above Fig. 8(b), except that a source electrode 151 and a drain electrode 155 are constituted by only an electroconductive film formed by the present invention. Although the resistance increases due to the lamination of no copper film, the film having a lower resistance can be obtained as compared to Al or the like.

The TFT panels of the present invention are used for liquid crystal displays, organic EL display devices, etc.

Although ITO is used as the component material of the transparent electrodes 71, 85 in the above description, the present invention is not limited thereto. Transparent electroconductive films made of various metal oxides besides ITO, such as a zinc oxide film or the like, can be used.

Further, the target portion 10 used for forming the electroconductive film is not particularly limited. For example, the target portion 10 may be constituted by a single plate of a target (alloy target) composed mainly of copper and containing one or more kinds of addition metals.

The shape of the alloy target is not particularly limited, and takes a planar shape (such as, rectangular, square or circular shape).

The alloy target is arranged inside the film forming chamber (first film forming chamber 2) in place of the target portion 10 in Fig. 1. An electroconductive film is formed by sputtering the alloy target in such a state that an object to be film-formed is arranged, while a face on which the electroconductive film is to be formed is faced toward the surface of the alloy target. When the target is magnetron sputtered, the magnetic field forming device 14 is arranged on a rear face side of the alloy target.

When the alloy target is sputtered, sputtered particles of the alloy of copper and the addition metal, sputtered ones of copper and sputtered ones of the addition metal are ejected from the target.

In summary, in a case where the target portion 10 is constituted by the alloy target and in a case where the target portion 10 is constituted by the main target 11 and the auxiliary target 12, copper atoms and addition metal atoms are ejected from the target portion 10 by sputtering, so that the electroconductive films (the first and second electroconductive films) containing both the copper atoms and the addition metal atoms grow on the surface of the object to be film-formed.

The above explanation has been made for a case in which the copper film 53 composed mainly of copper and the electroconductive films (the first and second electroconductive films 52, 54) are formed by using the different targets, but the present invention is not limited thereto.

For example, the electroconductive film is formed by sputtering the target portion 10 while the nitrogen gas and the sputtering gas are introduced into the interior of the first film forming chamber 2. The first film forming chamber 2 is evacuated to a vacuum and the partial pressure of the nitrogen gas inside the interior of the first film forming chamber 2 is reduced from that at the time of forming the electroconductive film. Consequently, the copper film may be formed by sputtering the same target portion 10 used for the formation of the electroconductive film.

In this case, although the copper film contains the same addition metal as in a case of the first and second electroconductive films, the resistivity of the copper film is smaller than those of the first and second electroconductive films because of the lower partial pressure of the nitrogen gas at the time of the film formation.

The first and second electroconductive films 52, 54 may be formed by using the same target portion 10, or they may be formed by using different target portions 10, so that the kinds and the contents of the addition metals may be changed. Further, the partial pressures of nitrogen at the time of the formation of the first and second electroconductive films 52, 54 may be the same or changed.

Although the annealing method is not particularly limited, the annealing is preferably performed in a vacuum atmosphere. In addition, when the object on which the electroconductive film has been formed is transferred into another film forming chamber or a heating device, it is preferable that the object to be film-formed is transferred in a vacuum atmosphere without being exposed to the atmosphere.

The sputtering gas is not limited to Ar; and Ne, Xe or the like can be used besides Ar. The electroconductive films formed by the present invention can be used for TFTs and electrodes and barrier films of TFT panels as well as barrier films and electrodes (wiring films) of other electric parts (such as, semiconductor elements or wiring boards).

When the electroconductive film and the copper film are laminated, the film thickness of the electroconductive film is not particularly limited. However, if it is too thick, the resistivity of the entire electrode becomes higher. Therefore, the film thickness of the electroconductive film is preferably 1/3 or less of that of the entire electrode. Further, when the adhesion and the diffusion preventing property for the silicon layer and the glass substrate are taken into consideration, the film thickness of the electroconductive film is preferably 10nm or more.

Furthermore, the nitriding gas is not particularly limited, as long as it is a gas containing a nitrogen atom in a chemical structure. NH₃, hydrazine, an amine-based alkyl compound, an azide compound, etc. can be used besides nitrogen (N₂). These nitriding gases may be used alone or two or more kinds of these nitriding gases may be used in a mixed state.

The transparent substrate is not limited to the glass substrate, and, for example, a quartz substrate and a plastic substrate can be used.

The kind of the silicon layer and the producing method which is employed in the present invention are not particularly limited. The kinds of silicon layer which are used as silicon layers in TFT, including a silicon layer (an amorphous silicon layer, a polysilicon layer) deposited by, for example, sputtering, vapor deposition or the like can be widely used.

As the addition metal to be used in the present invention, Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd are preferable. Only one kind thereof may be used to form an electroconductive film containing one kind of the addition metal, or two or more kinds of the addition metal may be used to form an electroconductive film containing two or more kinds of the addition metals. Among the above-mentioned addition metals, IV group elements (such as Ti and Zr) are particularly suitable for the present application.

The above explanation has been made for the so-called top gate type TFT having the gate electrode 67, 83 arranged on the surface of the silicon layer 61, 86, but the present invention is not limited thereto. According to the present invention, a so-called bottom gate type TFT can be produced by forming a gate electrode on a surface of a glass substrate.

In the following description, a fourth embodiment of a TFT as a bottom gate type TFT and a producing method therefor will be explained.

A substrate (for example, a glass substrate) is transferred as an object to be film-formed into the interior of the vacuum chamber 2 of the film forming apparatus 1 in Fig. 1.

An electroconductive body is formed on the surface of the substrate by laminating a first electroconductive film, a copper film and a second electroconductive film in the described order in the same steps as those explained in the above Figs. 7(a) to (c).

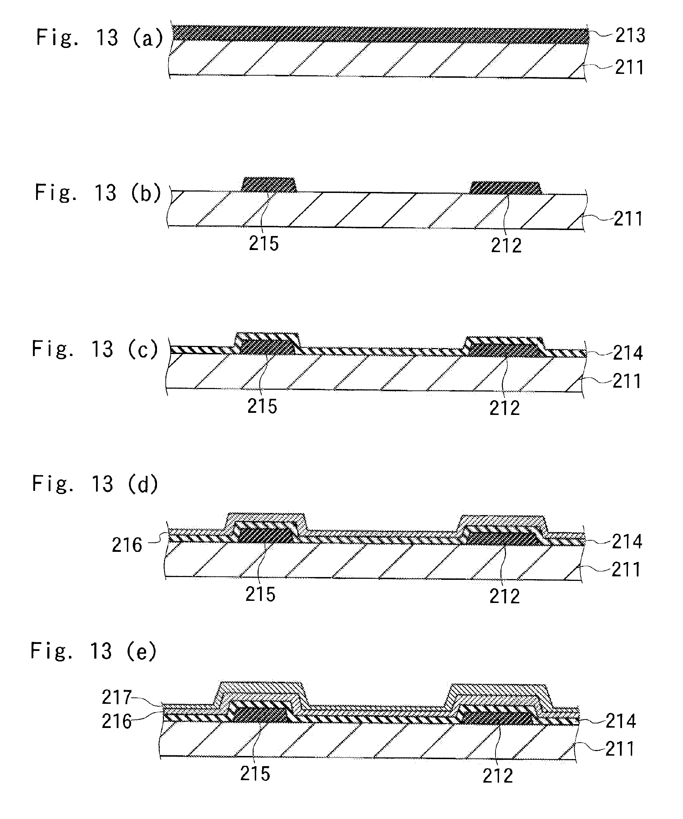

Fig. 13(a) shows a state in which the electroconductive body 213 is formed on the surface of the substrate 211.

Next, the electroconductive body 213 is patterned in a photographing step and an etching step, and a gate electrode 215 and a storage capacity electrode 212 are formed by the patterned electroconductive body 213, as shown in Fig. 13(b).

A gate insulating film 214 made of a film of silicon nitride (SiN), a film of silicon oxide (SiO₂ ) or a film of silicon nitride oxide (SiON) is formed, by a CVD method or the like, on that surface of the substrate 211 on which the gate electrode 215 and the storage capacity electrode 212 are formed.

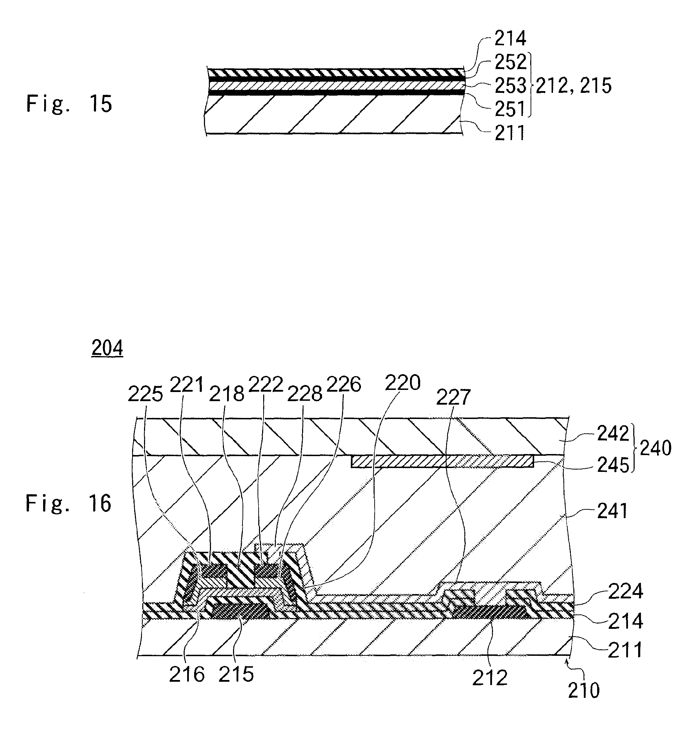

Fig. 15 is an enlarged sectional view of a portion in which the gate electrode 215 (or the storage capacity electrode 212) is arranged.

The gate electrode 215 and the storage capacity electrode 212 have the first and second electroconductive film 251, 252 and the copper film 253, as mentioned above. The first electroconductive film 251 is tightly adhered to the substrate 211; the second electroconductive film 252 is tightly adhered to the gate insulating film 214; and the copper film 253 is positioned between the first and second electroconductive films 251, 252.

Since the first and second electroconductive films 251, 252 contain nitrogen and the addition metal, they have high adhesion to the substrate 211 and the gate insulating film 214. In addition, since the copper film 253 having a low electric resistance is arranged between the first and second electroconductive films 251 and 252, the entire electric resistance of the gate electrode 215 and the storage capacity electrode 212 is low.

After the gate insulating film 214 is formed, a channel semiconductor layer (channel area) 216 made of, for example, amorphous silicon is formed on the surface of the gate insulating film 214 by the CVD method or the like (Fig. 13(d)).

Next, an ohmic layer 217 composed mainly of silicon and containing an impurity is formed on the surface of the channel semiconductor layer 216 by the CVD method or the like (Fig. 13(e)).

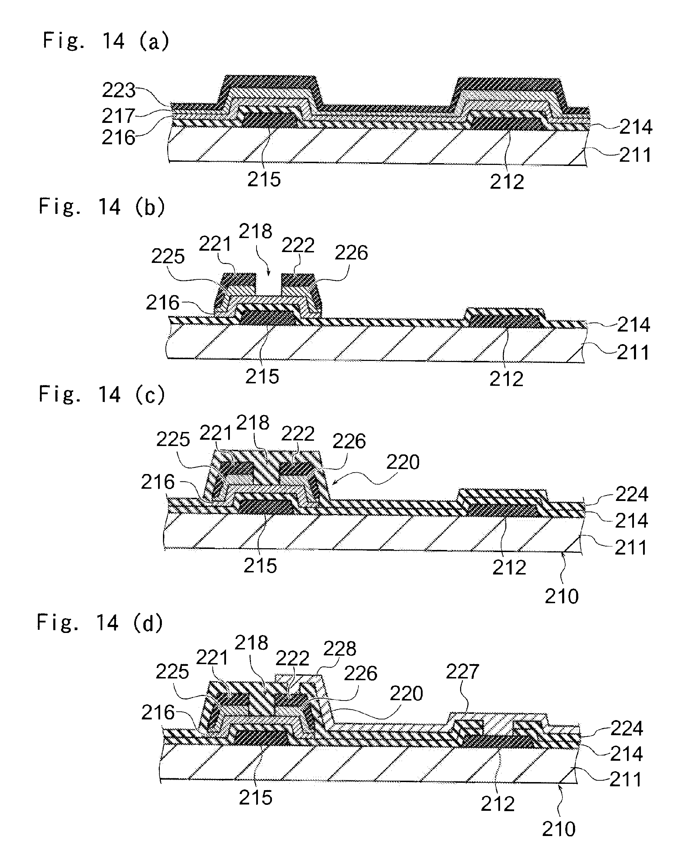

Then, the substrate 211 on which the ohmic layer 217 is formed is transferred into the vacuum chamber 2 of the film forming apparatus 1 in Fig. 1; and an electroconductive body 223 is formed by laminating a first electroconductive film 251, a copper layer 253 and a second electroconductive layer 252 in the described order by the same steps as in the film formation of the above-mentioned electroconductive body 213 (Fig. 14(a)).

Next, the electroconductive layer 223, the ohmic layer 217 and the channel semiconductor layer 216 are patterned by a photographing step and an etching step.

Based on the above-mentioned patterning, with respect to the channel semiconductor layer 216, that portion which is positioned immediately above the gate electrode 215 and portions located on the opposite sides of the gate electrode 215 are retained.

Based on this patterning, with respect to the ohmic layer 217 and the electroconductive body 223, that portion which is positioned immediately above the center of the gate electrode 215 at a place positioned on the channel semiconductor layer 216 is removed, and portions located on the opposite sides of the gate electrode 215 are retained.

In Fig. 14(b), reference numerals 225 and 226 indicate a source semiconductor layer (source area) and a drain semiconductor layer (drain area), respectively. The source semiconductor layer 225 and the drain semiconductor layer 226 are constituted by the portions retained on the opposite sides of the gate electrode 215 of the ohmic layer 217.

In the same figure, reference numerals 221, 222 indicate a source electrode and a drain electrode, respectively. The source electrode 221 and the drain electrode 222 are constituted by portions of the electroconductive body 223 retained on the opposite sides of the gate electrode 215.

Next, an interlayer insulating film 224 composed of a silicon nitride film, a silicon oxide film or a silicon nitride oxide is formed on the surfaces of the source electrode 221 and the drain electrode 222 by the CVD method or the like (Fig. 14(c)).

A reference numeral 220 in Fig. 14(c) indicates a thin film transistor (TFT) in which the interlayer insulating film 224 is formed. In the same figure, a reference numeral 210 indicates a thin film transistor-provided panel.

The source electrode 221 and the drain electrode 222 have the first and second electroconductive films 251, 252 and the copper film 253 as in a case with the gate electrode 215 and the storage capacity electrode 212. The first electroconductive film 251 is tightly adhered to the ohmic layer 217; the second electroconductive film 252 is tightly adhered to the interlayer insulating film 224; and the copper film 253 is positioned between the first and second electroconductive films 251 and 252.

The ohmic layer 217 has a main component of silicon. Since the first and second electroconductive films 251, 252 contain nitrogen and the addition metal, they have high adhesion to silicon and the insulating film. Therefore, the source electrode 221 and the drain electrode 222 are hardly peeled from the ohmic layer 217 and the interlayer insulating film 224. In addition, copper does not diffuse from the first and second electroconductive films 251, 252 into the ohmic layer 217.

In this thin film transistor 220, by means of an opening 218 positioned immediately above the center of the gate electrode 215, the source semiconductor layer 225 and the drain semiconductor layer 226 are separated from each other and the source electrode 221 and the drain electrode 222 are separated from each other. That opening 218 is filled with the interlayer insulating film 224.

The channel semiconductor layer 216 is the same electroconductive type as that of the source and drain semiconductor layers 225, 226, but its impurity concentration is lower.

When a voltage is applied to the gate electrode 215 in a state such that a voltage is applied between the source electrode 221 and the drain electrode 222 and a voltage is applied to the source semiconductor layer 225 and the drain semiconductor layer 226, a storage layer having a low resistance is formed on that portion of the channel semiconductor layer 216, which comes into contact with the gate electrode 215 via the gate insulating film 214. Consequently, the source semiconductor layer 225 and the drain semiconductor layer 226 are electrically connected via the storage layer; and electric current flows therebetween.

Meanwhile, the channel semiconductor layer 216 may be an electroconductive type opposite to that of the source and drain semiconductor layers 225, 226.

In this case, when a voltage is applied to the gate electrode 215 in a state such that a voltage is applied between the source semiconductor layer 225 and the drain semiconductor layer 226, an inversion layer of the same electroconductive type as that of the source and drain semiconductor layers 225, 226 is formed on that portion of the channel semiconductor layer 216, which comes into contact with the gate electrode 215 via the gate insulating film 214. The source semiconductor layer 225 and the drain semiconductor layer 226 are electrically connected through the inversion layer, and electric current flows therebetween.

Fig. 14(d) shows a state such that after windows are opened at a portion above the drain electrode 222 or the source electrode 221 (here, the drain electrode 222) of the interlayer insulating film 224 and at a portion above the storage capacity electrode 212, a patterned transparent electroconductive film is arranged on the interlayer insulating film 224.

In the same figure, a reference numeral 227 indicates a pixel electrode made of that portion of the transparent electroconductive film which is positioned on a side of the thin film transistor 220.

In the same figure, a reference numeral 228 indicates a connecting portion which is composed of that portion of the transparent electroconductive film which is positioned on the thin film transistor 220 and has contact with the drain electrode 222.

The pixel electrode 227 is electrically connected to the drain electrode 222 via the connecting portion 228, so that when the source semiconductor layer 225 is electrically connected to the drain semiconductor layer 226, electric current flows into the pixel electrode 227.

In Fig. 16, a reference numeral 204 indicates a liquid crystal display device in which liquid crystals 241 are arranged between a panel 240 and a substrate 211 on which the TFT 220 is formed.

The panel 240 has a glass substrate 242 and an opposed electrode 245 arranged on a surface of the glass substrate 242. The opposed electrode 245 and the pixel electrode 227 face each other across the liquid crystal 241.

The light transmission rate of the liquid crystals 241 can be changed by controlling the voltage to be applied between the pixel electrode 227 and the opposed electrode 245.

The liquid crystal display device 204 may be produced by using the substrate 211 on which any of the TFTs in the first to third embodiments is formed, instead of the TFT 220 in the fourth embodiment.

The electroconductive body 223 constituting the electrode is not limited to the three-layer structure, and at least one of the source electrode 221, the drain electrode 222, the gate electrode 215 and the storage capacity electrode 212 may be constituted by the first electroconductive film 251 alone.

Since the electroconductive film formed by the present invention has the main component of copper and contains the addition metal, it has high adhesion to the glass substrate, the silicon layer, the transparent electroconductive film, etc. Therefore, the object used to form an electroconductive film thereon may not be particularly limited.

For example, an object to be film-formed from which a transparent electroconductive film is exposed is used; and an electroconductive film is formed on the transparent electroconductive film. Alternatively, an object to be film-formed from which a glass substrate and a silicon layer are exposed is used; and an electroconductive film may be formed on a surface of the glass substrate and a surface of the silicon layer. Additionally, an object to be film-formed from which a glass substrate, a transparent electroconductive film and a silicon layer are exposed, respectively, is used; and an electroconductive film may be formed on a surface of the glass substrate, a surface of the transparent electroconductive film and a surface of the silicon layer, respectively.

## Claims

1. An electroconductive film-forming method for forming an electroconductive film composed mainly of copper and containing an addition metal on a surface of an object to be film-formed in a vacuum atmosphere by a sputtering method, the forming method comprising the steps of:
sputtering a target composed mainly of copper in the vacuum atmosphere, while feeding a nitriding gas having a nitrogen atom in a chemical structure thereof into the vacuum atmosphere;
ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target; and
forming the electroconductive film.

2. The electroconductive film-forming method according to claim 1, wherein the object to be film-formed is used, in which at least one of a silicon layer, a glass substrate and a transparent electroconductive film is exposed from a surface of the object.

3. The electroconductive film-forming method according to claim 2, wherein Ti is selected as the addition metal, a nitrogen gas is used as the nitriding gas, the nitrogen gas is introduced in such a manner that a partial pressure of the nitrogen gas to the total pressure of the vacuum atmosphere may be at least 0.1 % and at most 50 %, and Ti is contained in the electroconductive film by 0.1 atomic % or more.

4. A thin film transistor, comprising:
a gate electrode, a drain area composed mainly of silicon and a source area composed mainly of silicon,
wherein the drain area and the source area are electrically conducted when a voltage is applied to the gate electrode, and
wherein a first electroconductive film mainly composed of copper is formed on at least one of a surface of the drain area and a surface of the source area,
the first electroconductive film is formed by arranging in a vacuum atmosphere an object to be film-formed in which at least one of the drain area and the source area is exposed,
sputtering a target composed mainly of copper in the vacuum atmosphere, while feeding a nitriding gas having a nitrogen atom in a chemical structure into the vacuum atmosphere, and
ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target.

5. The thin film transistor according to claim 4, wherein the first electroconductive film contains Ti as the addition metal by at least 0.1 atomic % and the first electroconductive film is formed by feeding the nitriding gas composed of a nitrogen gas in such a manner that a partial pressure of the nitriding gas to the total pressure of the vacuum atmosphere may be at least 0.1 % to at most 50 %.

6. A thin film transistor-provided panel, comprising:
a substrate, a thin film transistor and a transparent electroconductive film disposed on a surface of the substrate, respectively,
wherein the thin film transistor is comprised of a gate electrode, a drain area composed mainly of silicon and a source area composed mainly of silicon,
wherein when a voltage is applied to the gate electrode, the drain area and the source area are electrically conducted and the transparent electroconductive film is connected to the source area;
a first electroconductive film composed mainly of copper is formed on at least one of a surface of the drain area and a surface of the source area,
wherein the first electroconductive film is formed by arranging, in a vacuum atmosphere, an object to be film-formed in which at least one of the drain area and the source area is exposed,
sputtering a target composed mainly of copper in the vacuum atmosphere while feeding a nitriding gas having a nitrogen atom in a chemical structure into the vacuum atmosphere, and
ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target.

7. The thin film transistor-provided panel according to claim 6, wherein the first electroconductive film is tightly adhered to both of the drain area and the transparent electroconductive film.

8. The thin film transistor-provided panel according to claim 6, wherein Ti is selected as the addition metal, a nitrogen gas is used as the nitriding gas, the nitrogen gas is introduced in such a manner that a partial pressure of the nitrogen gas to the total pressure of the vacuum atmosphere may be at least 0.1 % and at most 50 %, and Ti is contained in the first electroconductive film by 0.1 atomic % or more.

9. The thin film transistor-provided panel according to claim 6, wherein a second electroconductive film electrically connected to the first electroconductive film is disposed on a surface of the first electroconductive film,
wherein the transparent electroconductive film is arranged on a surface of the second electroconductive film, and
wherein the second electroconductive film is formed by arranging, in a vacuum atmosphere, the substrate in which the thin film transistor and the first electroconductive film have been formed,
sputtering a target composed mainly of copper in the vacuum atmosphere while feeding a nitriding gas having a nitrogen atom in a chemical structure into the vacuum atmosphere, and
ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target.

10. The thin film transistor-attached panel according to claim 9, wherein a copper film composed mainly of copper is arranged on a surface of the first electroconductive film, the object to be film-formed in which the copper film is exposed is used, and the second electroconductive film is formed on a surface of the copper film.

11. The thin film transistor-provided panel according to claim 9, wherein Ti is selected as the addition metal, a nitrogen gas is used as the nitriding gas, the nitrogen gas is introduced in such a manner that a partial pressure of the nitrogen gas to the total pressure of the vacuum atmosphere may be at least 0.1 % and at most 50 %, and Ti is contained in the second electroconductive film by at least 0.1 atomic %.

12. A process for producing a thin film transistor comprising an electroconductive film which has contact with at least one of a silicon layer composed mainly of silicon, a glass substrate and a transparent electroconductive film,
wherein the electroconductive film is composed mainly of copper, the producing process comprising the steps of:
sputtering a target composed mainly of copper in a vacuum atmosphere, while feeding a nitriding gas having a nitrogen atom in a chemical structure into the vacuum atmosphere, in a state such that an object to be film-formed in which at least one of the silicon layer, the glass substrate and the transparent electroconductive film is exposed is arranged in the vacuum atmosphere;
ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target; and
forming the electroconductive film.

13. The thin film transistor-producing method according to claim 12, wherein the nitriding gas is introduced in such a manner that a partial pressure of the nitriding gas to the total pressure of the vacuum atmosphere may be at least 0.1 % and at most 50 %, and the sputtering is performed.

14. A process for producing a thin film transistor having:
a silicon layer composed mainly of silicon,
a first electroconductive film contacting with the silicon layer,
a copper film composed mainly of copper and formed on a surface of the first electroconductive film, and
a second electroconductive film formed on a surface of the copper film,
wherein a transparent electroconductive film has contact with the second electroconductive film and the first and second electroconductive films are composed mainly of copper,
the thin film transistor-producing method, comprising the steps of:
sputtering a target composed mainly of copper in a vacuum atmosphere, while feeding a nitriding gas having a nitrogen atom in a chemical structure into the vacuum atmosphere;
ejecting copper atoms and atoms of any one kind of an addition metal selected from the group consisting of Ti, Zr, Hf, V, Nb, Ta, Cr, Mo, W, Mn, Fe, Ru, Os, Co, Ni, Bi, Ag, Zn, Sn, B, C, Al, Si, La, Ce, Pr and Nd from the target, and
forming at least one of the first and second electroconductive films.

15. The thin film transistor-producing process according to claim 14, wherein the nitriding gas is introduced in such a manner that a partial pressure of the nitriding gas to the total pressure of the vacuum atmosphere may be at least 0.1 % and at most 50 %, and the sputtering is performed.
